# EUROPÄISCHE PATENTSCHRIFT

(11) **EP 1 481 425 B1**
(45) Veröffentlichungstag und Bekanntmachung des Hinweises auf die Patenterteilung: **23.07.2008**
(21) Anmeldenummer: 03709631.0
(22) Anmeldetag: 25.02.2003
(51) Int. Cl.: H01L 29/786, H01L 21/336

(54) **SELBSTJUSTIERTES VERFAHREN ZUR HERSTELLUNG EINES DOPPEL-GATE MOSFET**
SELF-ALIGNED METHOD FOR PRODUCING A DOUBLE-GATE MOSFET
PROCEDE AUTO-ALIGNE DESTINE A LA FABRICATION D'UN TRANSISTOR MOSFET A DOUBLE GRILLE

(30) Priorität: 01.03.2002 DE 10208881
(43) Veröffentlichungstag der Anmeldung: 01.12.2004
(73) Patentinhaber: Forschungszentrum Jülich GmbH, 52425 Jülich (DE)
(72) Erfinder: ZHAO, Qing-Tai, 52428 Jülich (DE); MANTL, Siegfried, 52428 Jülich (DE)
(86) Internationale Anmeldenummer: PCT/DE2003/000499
(87) Internationale Veröffentlichungsnummer: WO 2003/075355

(56) Entgegenhaltungen:
- EP-A- 0 612 103
- DE-A- 19 928 564
- US-A- 5 120 666
- US-A- 5 372 959
- US-A- 5 646 058
- US-A- 5 965 914

## Beschreibung

Die Erfindung beschreibt ein selbstjustierendes Verfahren zur Herstellung eines Doppel-Gate MOSFETs.

Die Dimensionen von Halbleiterbauelementen, insbesondere von höchstintegrierten Feldeffekttransistoren (MOSFET), müssen kontinuierlich verkleinert werden, um die Forderungen nach höherer Leistungsfähigkeit und höhere Integrationsdichte erfüllen zu können. Diese extreme Skalierung zu Dimensionen von wenigen Dekananometer führt bei dem herkömmlichen Design von MOSFETs zu unkontrollierbaren Kurzkanaleffekten. Eine vielversprechende Lösung dieses Problems ist der Einsatz von Doppel-Gate MOSFETs, wo der Kanal durch zwei, sich gegenüberliegenden Gates gesteuert wird. Diese symmetrische Struktur hat eine Reihe von Vorteilen: höhere Steilheiten, kleinere parasitäre Kapazitäten und reduzierte Kurzkanaleffekte. Hinzu kommt, daß Doppel-Gate MOSFETs zu extrem kleinen Kanallängen skaliert werden können. Die minimal mögliche Kanallänge beträgt nur die halbe Kanallänge eines konventionellen MOSFETs.

Aus J.P. Colinge et al. (Silicon-On Insulator Gate All Around Device, IEDM 1990, pp. 595-598) ist bekannt, daß durch chemisches Ätzen eines Oxides ein Hohlraum und so ein dünner Si-Streifen auf einem SOI-Wafer erzeugt werden kann. Anschließend wurden die Gateelektroden rund um den Si-Streifen abgeschieden. Nachteilig bei diesem Verfahren ist allerdings, dass Top- und Bottom-Gate bei extrem kurzen Kanallängen nicht bzw. nur unter großen Schwierigkeiten perfekt justiert hergestellt werden können.

Aus H.-S.-P. Wong et al. (Self-aligned (Top and Bottom) Double-Gate MOSFET with a 25 nm Thick Silicon Channel, IEDM 1997, pp. 427-430) ist bekannt, Doppel-Gate MOSFETs unter Verwendung selektiver Epitaxieabscheidung zu realisieren. Bei diesem Verfahren ist allerdings nachteilig, dass Top- und Bottom-Gate-Dielektrikum in der Regel nicht die gleiche Schichtdicke aufweisen und das Verfahren insgesamt technologisch sehr anspruchsvoll zu sein scheint.

Aus DE 199 24 571 C2 ist ein Doppel-Gate MOSFET bekannt, bei dem nachteilig Source und Drain aus einer anderen Schicht (Material) als die Kanalschicht bestehen. Die neue Grenzfläche kann zu unerwünschten Verunreinigungen bei der Kontaktierung der Kanalschicht führen.

Aus DE 199 28 564 A1 ist ein weiteres Verfahren zur Herstellung eines Mehrkanal-MOSFET bekannt.

Die bisher bekannten Verfahren zur Herstellung von Doppel-Gate Transistoren sind entweder sehr schwierig in der Ausführung oder weisen prinzipielle Schwächen bei der Kontrolle der vielen kritischen Designparameter auf. Aufgabe der Erfindung ist es, ein Verfahren zur Herstellung eines Doppel-Gate MOSFET bereit zu stellen,
bei dem zumindest Top- und Bottom-Gate sowie Source und Drain selbstjustierend erzeugt werden können, so dass diese perfekt innerhalb des Transistors ausgerichtet sind. Das Verfahren soll einfach und effizient in der Herstellung sein und die oben genannten Nachteile im Stand der Technik vermeiden.

Aufgabe der Erfindung ist es weiterhin, eine Schichtstruktur bereit zu stellen, aus der in einfacher Weise ein Doppel-Gate-MOSFET hergestellt werden kann, sowie die Bereitstellung eines entsprechenden Doppel-Gate-MOSFET.

Die Aufgabe wird durch ein Verfahren gemäß Patentanspruch 1 gelöst. Vorteilhafte Ausgestaltungen ergeben sich aus den darauf rückbezogenen Ansprüchen.

Das Verfahren gemäß Patentanspruch 1 umfasst folgende Prozessschritte:
a) Verwendung einer Schichtstruktur, umfassend ein Trägersubstrat, eine Halbleiterschicht sowie eine dazwischen angeordnete, vergrabene Schicht,
b) Bildung einer ersten Isolatorschicht auf der Halbleiterschicht,
c) Bildung einer Schutzschicht auf der zuerst gebildeten Isolatorschicht,
d) Herstellung einer Mesastruktur durch Bearbeitung der Schichtstruktur bis zur Oberfläche des Trägersubstrats. Hierdurch wird im Doppel-Gate MOSFET die Breite von Source- und Drain-Bereichen festgelegt.
e) Selektive, laterale Unterätzung der zuerst gebildeten Isolatorschicht und der vergrabenen Schicht, bis die verbleibende Breite der gebildeten Schichten der gewünschten Kanallänge des Doppel-Gate MOSFETs entspricht,
f) Selektive Entfernung der Schutzschicht,
g) Herstellung der Source- und Drain-Bereiche in der Halbleiterschicht.
   Die zuerst gebildete Isolatorschicht dient dabei als Maske zum Schutz des Kanals der Halbleiterschicht bei der Dotierung der Source- und Drain-Bereiche.
h) Bildung einer zweiten Isolatorschicht auf der bestehenden Struktur, um auch die durch Ätzen erzeugten Bereiche (Hohlräume) unter der Halbleiterschicht zu füllen,
i) Bildung einer Öffnung in der Mesastruktur mit einer Tiefe bis zum Trägersubstrat oder mit einer gewissen Tiefe bis in die vergrabene Schicht,
j) Bildung von Tunneln entlang der Mesastruktur in der zuerst gebildeten Isolatorschicht und in der vergrabenen Schicht mittels selektiven Ätzens. Durch zumindest teilweise Entfernung des verbliebenen Materials der zuerst gebildeten Isolatorschicht und der vergrabenen Schicht werden Tunnel entlang der Mesastruktur erzeugt. Die Tunnellänge definiert die Kanalweite des Transistors.
k) Bildung der Gatedielektrika in den geschaffenen Tunneln auf beiden Seiten der Halbleiterschicht,
l) Bildung der Gateelektroden auf den Gatedielektrika. Die Ausbildung der Gateelektroden (Top- und Bottom-Elektrode) erfolgt dabei selbstjustierend.

Die Erfindung beschreibt somit ein neues Verfahren zur Herstellung von Doppel-Gate MOSFETs, bei dem durch konventionelle optische Lithographie und selektivem Ätzen zunächst sehr kleine Strukturen von beispielsweise 10 Nanometer oder einige 10 Nanometer realisiert werden.

Es wurde im Rahmen der Erfindung erkannt, dass das in den Prozessschritten e) und j) geschilderte kontrollierte Ätzen der zuerst gebildeten Isolatorschicht und der in der Schichtstruktur vergrabenen Schicht eine Schichtstruktur bereit stellt, welche besonders vorteilhaft zur Herstellung eines perfekt justierten Doppel-Gate MOSFET herangezogen werden kann.

Die zuerst gebildete Isolatorschicht und die vergrabene Schicht werden nach selektivem Unterätzen und Bildung einer Öffnung in der Mesastruktur erneut geätzt um Tunnel zu bilden. Die Abmessungen der Tunnel und damit die der Gateelektroden werden also durch selektives mehrfaches Ätzen gebildet, wobei entsprechend die vergrabene Schicht selektiv ätzbar sein muß.

Durch die Bildung der Tunnel ist es möglich, das Gatedielektrikum und die obere und die untere Gateelektrode an beiden Seiten der Halbleiterschicht selbstjustierend zu erzeugen. Das obere und das untere Gate sind sowohl zueinander als auch zu den Source- und Drain-Bereichen perfekt justiert.

Ein auf diese Weise hergestellter Doppel-Gate-MOSFET-Transistor weist ein Trägersubstrat, insbesondere ein Siliziumsubstrat und ein darauf aufgebrachtes erstes Gate auf. Auf dem ersten Gate ist eine breitere Halbleiterschicht, umfassend Source- und Drain-Bereiche sowie einen zwischen Source- und Drain-Bereichen angeordneter Kanal, welcher sich exakt über der ersten Gateelektrode des Transistors befindet, angeordnet. Exakt über dem Kanal ist eine zweite Gateelektrode angeordnet. Exakt zwischen der unteren Gateelektrode und dem Kanal des Transistors sowie zwischen der oberen Gateelektrode und dem Kanal des Transistors ist jeweils ein Gatedielektrikum angeordnet. Auf dem Trägersubstrat ist eine weitere Isolatorschicht in der Weise angeordnet, dass die Struktur aus oberer und unterer Gateelektrode, den genannten Gatedielektrika und der Halbleiterschicht umfassend Source, Drain und Kanal in dieser weiteren Isolatorschicht eingebettet ist. Damit ist gemeint, dass auch die Hohlräume unterhalb der Halbleiterschicht durch isolierendes Material ausgefüllt sind.

Vorzugsweise wird die Halbleiterschicht zur Einstellung der Schwellspannung des Transistors gezielt dotiert,
wie dies bei der Prozessierung von konventionellen MOSFETs üblich ist.

Als Material für die zuerst gebildete Isolatorschicht kann das gleiche Material wie für die vergrabene Schicht verwendet werden.
Dadurch wird die weitere Prozessierung der Struktur wesentlich vereinfacht.

Alle Ätzprozesse können mit Standard-Verfahren der Siliziumtechnologie ausgeführt werden. Sowohl Trockenals auch Naßprozesse können eingesetzt werden. Für das selektive Ätzen bietet sich wegen der Einfachheit naßchemisches Ätzen an.
Dies ermöglicht eine vergleichsweise einfache Herstellung des Doppel-Gate MOSFETs.

In einer weiteren Ausgestaltung der Erfindung wird eine spiegelsymmetrische Struktur aus der zuerst gebildeten Isolatorschicht und aus der vergrabenen Schicht relativ zur halbleitenden Kanalschicht erzeugt.
Über die Breite der beiden zurückgeätzten Schichten wird die Kanallänge des Doppel-Gate MOSFETs definiert. Die Spiegelsymmetrie erlaubt die Bildung perfekt zueinander ausgerichteter Gatekontakte.

Die Bildung der zweiten Isolatorschicht geschieht besonders vorteilhaft über Abscheidung mittels Gasphasendeposition, um auch die Hohlräume vollständig auszufüllen.

Weiterhin kann eine zusätzliche Implantation für Source- und Drain-Extensions mit Spacern durchgeführt werden. Dabei werden zunächst die Spacer, welche die Funktion einer Maske ausüben, seitlich an der zuerst gebildeten Isolatorschicht und nur in unmittelbarer Nähe des Kanals angeordnet und so dann eine weitere Ionenimplantation durchgeführt.
Auf diese Weise wird erreicht, daß Drain- und Source-Bereiche mit niedrig dotierten Ausläufern zum Inversionskanal, sogenannten Extensions, selbstjustierend ausgeführt werden können. Diese Dotierungsanpassungen reduzieren störende Kurzkanaleffekte.

Zur Aktivierung der Dotieratome kann die Schichtstruktur getempert werden.

In einer besonders vorteilhaften Ausgestaltung der Erfindung wird die Öffnung in der Mesatruktur in Form eines Quergrabens gebildet. Die Öffnung bzw. der Quergraben ist breiter als das nach der Unterätzung verbliebene Material der zuerst gebildeten Isolatorschicht. Dadurch ist gewährleistet, daß die Kanallänge über die gesamte Kanalweite einheitlich ausgeführt wird.

Mit einem selektivem Ätzmittel, z. B. mit einer speziellen Säure falls naßchemisch geätzt wird, wird das verbliebene Material der zuerst gebildeten Isolatorschicht und/oder der vergrabenen Schicht selektiv und zumindest teilweise entfernt. Dadurch werden vorzugsweise gleich lange Tunnel ober- und unterhalb des Kanals der Halbleiterschicht erzeugt. Die Länge der Tunnel in der Mesastruktur entspricht besonders vorteilhaft der Kanalweite des Doppel-Gate MOSFETs.

Die Schichtdicke des Kanals ist durch Oxidation und Ätzen oder nur durch Ätzen reduzierbar. Dies bedeutet, dass vorteilhaft nicht nur Grenzflächeninversionskanäle wie in konventionellen MOSFETs sondern ein Volumeninversionskanal mit besonders hoher Performance realisiert werden kann. Ein weiterer Vorteil ist, dass der Kanalbereich dünner ausgeführt werden kann als die Source- und Drain-Bereiche, was den Serienwiderstand des Transistors reduziert.

Als Gatedielektrikum kann thermisch erzeugtes Siliziumdioxid, oder Oxinitride oder ein high-K Material verwendet werden. Hierunter ist gemeint, dass Materialien mit hoher Dielektrizitätskonstante, wie beispielsweise stickstoffhaltiges Siliziumdioxid, Zirkonoxid oder Hafniumoxid oder Silikate oder oxidische Perovskite, wie z. B. Lanthanaluminat als high-K Materialien, gebildet bzw. eingebracht werden. Dadurch können völlig neue Gatestacks vorteilhaft eingesetzt werden.

Als Material für die Gateelektroden kann insbesondere hoch dotiertes Poly-Silizium als besonders guter Leiter verwendet werden. Es kann ohne Einschränkung der Erfindung jedoch genauso gut auch ein geeignetes Metall verwendet werden, so lange gewährleistet ist, dass das Gatematerial ausreichend homogen auf dem Dielektrikum aufgebracht werden kann.

Aufgrund des konformen Abscheidungsverhaltens während der Gasphasendeposition kann dieses Verfahren dafür vorteilhaft eingesetzt werden. Standard Gasphasendepositionsverfahren von Metallen, wie z. B. von Wolfram- oder Titansilizid können eingesetzt werden.

Weitere Prozessschritte können selektives Wachstum in den Kontaktlochöffnungen von Source und Drain zur Herstellung von "elevated Source- und Drain-Kontakten" zur Reduzierung des Serienwiderstandes umfassen. Source, Drain und Gateelektroden können anschließend wie in Standardprozessen silizidiert und metallisiert werden.

Das erfindungsgemäße Verfahren gewährleistet somit, dass Source und Drain selbstjustierend zu dem Doppel-Gate erzeugt werden.

Das Verfahren zur Herstellung des Doppel-Gate MOSFETs kann weiterhin chemisch mechanisches Polieren (CMP) zur Planarisierung und Metallisierungsschritte zur Verdrahtung einschließen.

Im Folgenden wird die Erfindung an Hand eines Ausführungsbeispiels und der beigefügten Figuren näher erläutert.

Es zeigen:
- Fig. 1:: Querschnitt der Struktur nach Bildung einer Schutzschicht (Prozessschritt c))
- Fig. 2:: Querschnitt nach Bearbeitung der Struktur zur Bildung einer Mesastruktur (Prozessschritt d))
- Fig. 3:: Querschnitt der Struktur nach selektivem lateralem Unterätzen (Prozeßschritt e)) der zuerst gebildeten Isolatorschicht und der vergrabenen Schicht
- Fig. 4:: Struktur nach Entfernen der Schutzschicht. Die Struktur wird zur Bildung von Source- und Drain-Bereichen z. B. implantiert (Pfeile) (Prozeßschritte f) und g))
- Fig. 5:: Querschnitt der Struktur nach Bildung einer zweiten Isolatorschicht (Prozeßschritt h))
- Fig. 6:: Aufsicht auf die gebildete Struktur nach Bildung eines Quergrabens als Öffnung in der Mesastruktur (Prozeßschritt i))
- Fig. 7A:: Querschnitt der Struktur nach Bildung der Tunnel in der zuerst gebildeten Isolatorschicht und in der vergrabenen Schicht der Mesastruktur (Prozeßschritt j))
- Fig. 7B:: Querschnitt entlang der Mesastruktur vom linken Rand des Transistors bis zum Quergraben. Fig. 7B ist gegenüber Fig. 7A um 90 ° gedreht. Die zuerst gebildete Isolatorschicht und die vergrabene Schicht sind zum Teil selektiv aus der Schichtstruktur durch Ätzen entfernt worden. Die dadurch gebildeten Tunnel in der Mesastruktur definieren die Gateweite.
- Fig. 8:: Querschnitt nach Bildung der Gatedielektrika und Gateelektroden (Prozessschritte k) und l))

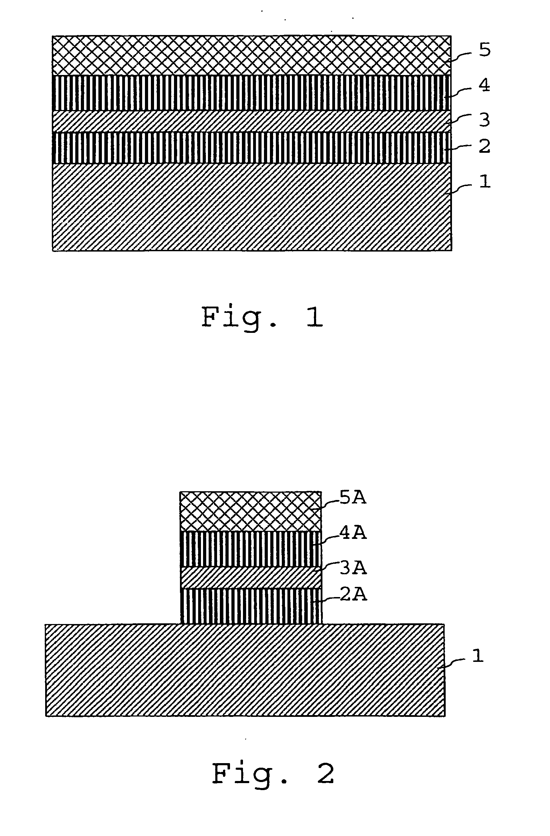

Eine SOI-Struktur (silicon-on-insulator) (SIMOX oder BESOI Wafer) umfassend einen dünnen (< 50 Nanometer) Si-Film 3 an der Oberfläche, einer vergrabenen Schicht 2 aus SiO₂ als selektiv ätzbares Material und ein Trägersubstrat 1 wird als Ausgangsstruktur verwendet. Eine erste Isolatorschicht 4, z. B. aus SiO₂, wird deponiert oder durch thermische Oxidation gebildet, wodurch vorteilhaft die Schichtdicke des Si-Oberflächenfilms reduziert wird. Anschließend wird eine Schutzschicht 5, z. B. aus Si₃N₄, auf der Schicht 4 abgeschieden oder anders gebildet. Die so entstandene Struktur ist in Fig. 1 dargestellt.

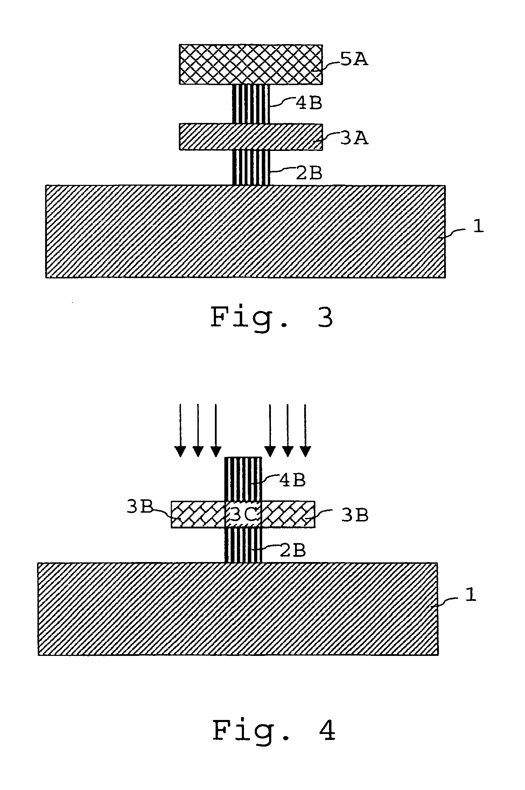

Fig. 2 zeigt die Mesastruktur 1, 2A, 3A, 4A und 5A nach Lithographie und Abätzen bis zur Oberfläche des Trägersubstrats 1. Es folgt ein gut kontrolliertes, selektives seitliches Unterätzen der zuerst gebildeten Isolatorschicht 4A und der vergrabenen Schicht 2A (Fig. 2), so dass die erfindungsgemäße Struktur von Fig. 3 mit den Schichten 2B und 4B entsteht. Die Breiten (< 100 Nanometer) der Schichten 2B und 4B sind identisch.

Nach Entfernen der Schutzschicht 5A werden die Source- und Drain-Bereiche 3B, z. B. durch Implantation der Dotieratome (Pfeile) gebildet (Fig. 4). Dabei dient die Schicht 4B als selbstjustierende Maske. Fig. 4 zeigt die gebildeten Source-und Drain-Bereiche 3B und den durch Maskierung unveränderten Kanalbereich 3C in der auf diese Weise gebildeten Struktur. Es kann notwendig sein im Anschluß hieran die Struktur ähnlich wie in Standardherstellungsprozessen von Halbleiterbauelementen zu tempern. Diese thermische Behandlung dient der elektrischen Aktivierung der implantierten Ionen bzw. Atome. Andere Dotierprozesse, wie z. B. Eindiffusion oder Laserdotierung können ebenso verwendet werden.

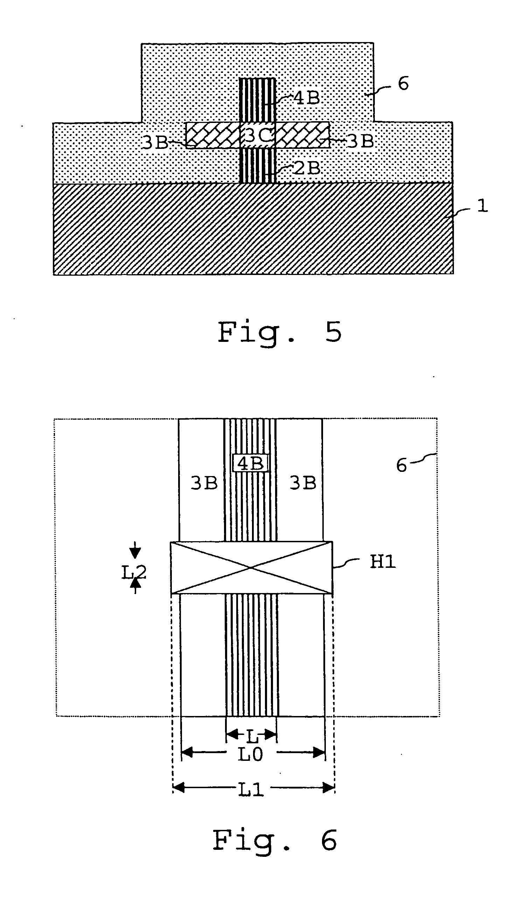

Anschließend wird eine zweite Isolatorschicht 6, z.B. aus Si₃N₄, mittels Gasphasendeposition abgeschieden. Dabei werden auch die Höhlräume unterhalb der Source-und Drain-Bereiche 3B in Fig. 4 ausgefüllt und es entsteht die Struktur von Fig. 5.

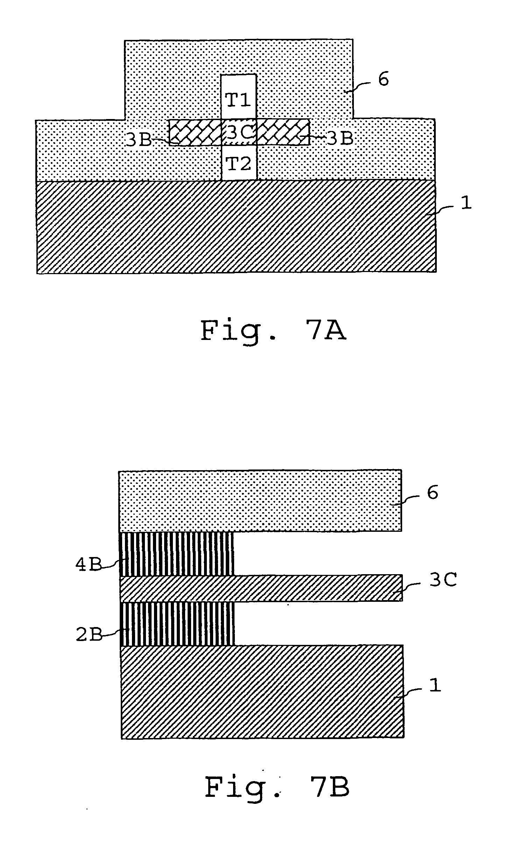

In der Mesastruktur wird durch Ätzen bis an die Grenzfläche von der Halbleiterschicht 3B, 3C an die vergrabene Schicht 2B oder direkt bis in die vergrabene Schicht 2B eine Öffnung, hier in Form eines Quergrabens H1, mit Dimensionen L1 x L2 erzeugt (Fig. 6). L0 bezeichnet die ursprüngliche Breite der Mesastruktur (Fig. 2) und L die Breite der Schicht 4B. Dann werden durch Entfernen der Schichten 2B und 4B mittels selektivem Ätzen, z.B. mittels naßchemischen Ätzen bis zu einer gewissen Tiefe, welche die Kanalweite festlegt, Tunnel T1, T2 oberhalb und unterhalb des Kanals 3C entlang der Mesastruktur gebildet. Fig. 7A zeigt einen Querschnitt und Fig. 7B eine zu Fig. 7A um 90 ° gedrehte Ansicht der so entstandenen Struktur. Der Ätzschritt, der die Tunnel durch zumindest teilweiser Entfernung der Schichten 2B und 4B bildet, verläuft in Fig. 7A also in der Tiefe. In Fig. 7B ist nur der Teil links des gebildeten Quergrabens H1 dargestellt. Mit einem für die Schichten 2B und 4B, also im vorliegenden Fall für SiO₂, selektiven Ätzmittel werden vom Quergraben ausgehend die Tunnel T1 und T2 gebildet. Die Tunnellänge, d. h. die weggeätzten Bereiche der Schichten 2B und 4B in Fig. 7B definieren die Gateweite des Doppel-Gate MOSFETs.

Anschließend werden die beiden Gate-Dielektrika 7, z. B. aus SiO₂, auf dem halbleitenden Material ober- und unterhalb des Kanals 3C gebildet. Dies erfolgt z. B. durch Oxidation oder Wachstum mit den in der Siliziumtechnologie üblichen Prozessen. Danach werden die Tunnel mit einem elektrisch leitenden Material 8 aufgefüllt. Die Gateelektroden werden so selbstjustierend hergestellt. Dieser Schritt kann z. B. mittels Gasphasendeposition von hoch dotiertem Poly-Silizium durchgeführt werden. Es kann aber ohne Einschränkung der Erfindung zur Bildung der Gateelektroden auch ein Metall, z. B. Wolfram mittels Gasphasendeposition abgeschieden werden.

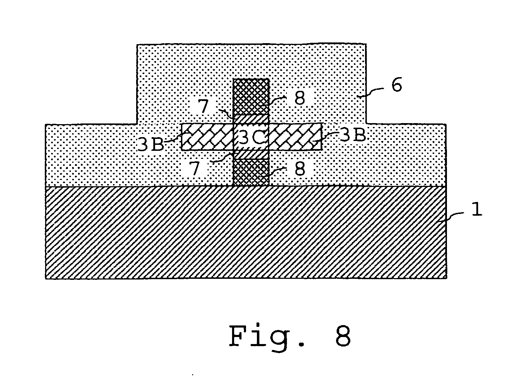

Fig. 8 zeigt einen Querschnitt eines mit diesem Verfahren hergestellten Doppel-Gate-MOSFET-Transistors, wobei der Kanal mit 3C, die Source- und Drain-Bereiche mit jeweils 3B, die beiden Gatedielektrika mit jeweils 7 und die beiden Gateelektroden jeweils mit 8 bezeichnet sind.

Das Verfahren dient auf diese Weise der Implementierung der Erfindung in die hochintegrierte Silizium-Technologie. Es können aber auch andere Materialien verwendet werden.
So ist es möglich, dass das Träger-Substrat 1 aus Silizium (Si), die vergrabene Schicht 2 aus Siliziumgermanium (SiGe) und der Halbleiter 3 wiederum aus Silizium (Si) besteht.
Es ist auch möglich, daß das Träger-Substrat 1 aus Galliumarsenid (GaAs), die vergrabene Schicht 2 aus Aluminiumgalliumarsenid (AlGaAs) und der Halbleiter 3 wiederum aus Galliumarsenid (GaAs) besteht.
Es ist weiterhin möglich, daß das Träger-Substrat 1 aus Galliumnitrid (GaN), die vergrabene Schicht 2 aus Aluminiumgalliumnitrid (AlGaN) und der Halbleiter 3 wiederum aus Galliumnitrid (GaN) besteht.
Es ist darüber hinaus auch denkbar, Verbindungen der III bzw. V Hauptgruppe des Periodensystems und der III-Nitride zu verwenden, die selektiv ätzbar im Sinne der Erfindung sind, d.h. das die Prozeßschritte e), i) und j) mit naßchemischen bzw. trockenchemischen Ätzen ätzbar sind.

## Patentansprüche

1. Verfahren zur Herstellung eines Doppel-Gate-MOSFET umfassend die Schritte:
(a) Verwendung einer Schichtstruktur, umfassend ein Trägersubstrat (1), eine Halbleiterschicht (3) sowie eine dazwischen angeordnete, vergrabene Schicht (2),
(b) Bildung einer ersten Isolatorschicht (4) auf der Halbleiterschicht (3),
(c) Bildung einer Schutzschicht (5) auf der zuerst gebildeten Isolatorschicht (4),
(d) Herstellung einer Mesastruktur (1, 2A, 3A, 4A, 5A) aus der Schichtstruktur (1, 2, 3, 4, 5),
(e) Selektive, laterale Unterätzung der zuerst gebildeten Isolatorschicht (4A) und der vergrabenen Schicht (2A), bis die verbleibende Breite der gebildeten Schichten (2B, 4B) der gewünschten Kanallänge des Doppel-Gate MOSFETs entspricht,
(f) Selektive Entfernung der Schutzschicht (5A),
(g) Herstellung der Source- und Drain-Bereiche (3B) in der Halbleiterschicht (3), wobei die zuerst gebildete Isolatorschicht (4B) als Maske zum Schutz des Kanals (3C) der Halbleiterschicht bei der Dotierung der Source- und Drainbereiche (3B) dient,
(h) Bildung einer zweiten Isolatorschicht (6) auf der bestehenden Schichtstruktur (1, 2B, 3B, 3C und 4B),
(i) Bildung einer Öffnung in der Mesastruktur mit einer Tiefe bis zum Trägersubstrat (1) oder bis in die vergrabene Schicht (2B),
(j) Bildung von Tunneln (T1, T2) entlang der Mesastruktur in der zuerst gebildeten Isolatorschicht (4B) und in der vergrabenen Schicht (2B),
(k) Bildung der Gatedielektrika (7) auf beiden Seiten der Halbleiterschicht (3),
(l) Bildung der Gateelektroden (8) auf den Gatedielektrika (7).

2. Verfahren nach Anspruch 1, wobei die Halbleiterschicht (3) zur Einstellung der Schwellspannung des Transistors gezielt dotiert wird.

3. Verfahren nach einem der vorhergehenden Ansprüche,
**dadurch gekennzeichnet, dass**
das gleiche Material für die zuerst gebildete Isolatorschicht (4, 4A, 4B) und für die vergrabene Schicht (2, 2A, 2B) verwendet wird.

4. Verfahren nach einem der vorhergehenden Ansprüche,
**dadurch gekennzeichnet, dass**
das selektive laterale Unterätzen mittels nasschemischen Ätzen und/oder Trockenätzen durchgeführt wird.

5. Verfahren nach einem der vorhergehenden Ansprüche,
**dadurch gekennzeichnet, dass**
eine spiegelsymmetrische Struktur aus der zuerst gebildeten Isolatorschicht (4B) und aus der vergrabenen Schicht (2B) relativ zur halbleitenden Kanalschicht (3C) erzeugt wird.

6. Verfahren nach einem der vorhergehenden Ansprüche,
**dadurch gekennzeichnet, dass**
die zweite Isolatorschicht (6) mittels Gasphasendeposition abgeschieden wird.

7. Verfahren nach einem der vorhergehenden Ansprüche,
**dadurch gekennzeichnet, dass**
eine zusätzliche Implantation für Source und Drain Extensions mit Spacem an der zuerst gebildeten Isolatorschicht (4B) durchgeführt wird.

8. Verfahren nach einem der vorhergehenden Ansprüche,
**dadurch gekennzeichnet, dass**
die Struktur zur Aktivierung der Dotieratome getempert wird.

9. Verfahren nach einem der vorhergehenden Ansprüche,
**dadurch gekennzeichnet, dass**
die Öffnung in der Mesastruktur in Form eines Quergrabens (H1) gebildet wird, wobei die Breite (L1) des Quergrabens (H1) breiter ist als die Breite (L) der zuerst gebildeten Isolatorschicht (4B).

10. Verfahren nach einem der vorhergehenden Ansprüche,
**dadurch gekennzeichnet, dass**
die Tunnel (T1, T2) durch selektives, nasschemisches Ätzen gebildet werden.

11. Verfahren nach einem der vorhergehenden Ansprüche,
**dadurch gekennzeichnet, dass**
die Länge der Tunnel (T1, T2) der Kanalweite des Doppel-Gate MOSFETs entsprechen.

12. Verfahren nach einem der vorhergehenden Ansprüche,
**dadurch gekennzeichnet, dass**
die Schichtdicke der Kanalschicht (3C) durch Oxidation oder Ätzen reduziert wird.

13. Verfahren nach einem der vorhergehenden Ansprüche,
**dadurch gekennzeichnet, dass**
als Gatedielektrikum (7) thermisch erzeugtes Siliziumdioxid, oder Oxinitride oder ein high-K Material wie Hafniumoxid oder Zirkonoxid oder Silikate oder oxidische Perovskite verwendet wird.

14. Verfahren nach einem der vorhergehenden Ansprüche,
**dadurch gekennzeichnet, dass**
zur Bildung der Gateelektroden (8) hoch dotiertes Poly-Silizium verwendet wird.

15. Verfahren nach einem der vorhergehenden Ansprüche,
**dadurch gekennzeichnet, dass**
zur Bildung der Gateelektroden (8) ein Metall mittels Gasphasendeposition abgeschieden wird.

## Claims

1. Method for producing a double gate MOSFET comprising the steps:
(a) Use of a layer structure, comprising a carrier substrate (1), a semiconductor layer (3) and a buried layer arranged in between (2),
(b) Formation of a first insulating layer (4) on the semiconductor layer (3),
(c) Formation of a protective layer (5) on the insulating layer first formed (4),
(d) Production of a mesa structure (1, 2A, 3A, 4A, 5A) from the layer structure (1, 2, 3, 4, 5),
(e) Selective, lateral undercutting of the insulating layer first formed (4A) and the buried layer (2A) until the remaining width of the layers formed (2B, 4B) corresponds to the desired channel length of the double gate MOSFET,
(f) Selective removal of the protective layer (5A),
(g) Production of the source and drain areas (3B) in the semiconductor layer (3), in which the insulating layer first formed (4B) serves as a mask to protect the channel (3C) of the semiconductor layer when doping the source and drain areas (3B),
(h) Formation of a second insulating layer (6) on the existing layer structure (1, 2B, 3B, 3C and 4B),
(i) Formation of an opening in the mesa structure with a depth going as far as the carrier substrate (1) or as far as the buried layer (2B),
(j) Formation of tunnels (T1, T2) along the mesa structure in the insulating layer first formed (4B) and in the buried layer (2B),
(k) Formation of the gate dielectrics (7) on both sides of the semiconductor layer (3),
(l) Formation of the gate electrodes (8) on the gate dialectrics (7).

2. Method according to claim 1, in which the semiconductor layer (3) is doped to adjust the threshold voltage of the transistor in a targeted way.

3. Method according to one of the previous claims,
**characterised in that**
the same material is used for the insulation layer first formed (4, 4A, 4B) and for the buried layer (2, 2A, 2B).

4. Method according to one of the previous claims,
**characterised in that**
selective lateral undercutting is carried out by means of wet chemical etching and/or dry etching.

5. Method according to one of the previous claims,
**characterised in that**
a structure is produced from the insulating layer first formed (4B) and the buried layer (2B), which has mirror type symmetry in relation to the semiconducting channel layer (3C).

6. Method according to one of the previous claims,
**characterised in that**
the second insulating layer (6) is separated by means of gas phase deposition.

7. Method according to one of the previous claims,
**characterised in that**
additional implantation for source and drain extensions with spacers is carried out on the insulating layer first formed (4B).

8. Method according to one of the previous claims,
**characterised in that**
the structure is tempered to activate the doping atoms.

9. Method according to one of the previous claims,
**characterised in that**
the opening in the mesa structure is made in the form of a transverse trench (H1), in which the width (L1) of the transverse trench (H1) is wider than the width (L) of the insulating layer first formed (4B).

10. Method according to one of the previous claims,
**characterised in that**
the tunnels (T1, T2) are formed by selective, wet chemical etching.

11. Method according to one of the previous claims,
**characterised in that**
the length of the tunnels (T1, T2) corresponds to the channel width of the double gate MOSFET.

12. Method according to one of the previous claims,
**characterised in that**
the layer thickness of the channel layer (3C) is reduced by oxidation or etching.

13. Method according to one of the previous claims,
**characterised in that**
thermally produced silicon dioxide or oxynitrides or a high K material such as hafnium oxide or zirconium oxide or silicates or oxidic perovskites are used as the gate dieletric (7).

14. Method according to one of the previous claims,
**characterised in that**
highly doped polysilicon is used to form the gate electrodes (8).

15. Method according to one of the previous claims,
**characterised in that**
a metal is separated by means of gas phase deposition to form the gate electrodes (8).

## Revendications

1. Procédé pour la fabrication d'un transistor à effet de champ à métal-oxyde-semi-conducteur (MOSFET) à double grille comprenant les étapes de :
(a) utilisation d'une structure stratifiée comportant un substrat porteur (1), une couche semi-conductrice (3) ainsi qu'une couche noyée (2) placée entre ceux-ci,
(b) formation d'une première couche d'isolant (4) sur la couche semi-conductrice (3),
(c) formation d'une couche de protection (5) sur la couche d'isolant (4) formée en premier,
(d) élaboration d'une structure mesa (1, 2A, 3A, 4A, 5A) à partir de la structure stratifiée (1, 2, 3, 4, 5),
(e) gravure sous-jacente latérale sélective de la couche d'isolant (4A) formée en premier et de la couche noyée (2A) jusqu'à ce que la largeur restante des couches formées (2B, 4B) corresponde à la longueur de canal souhaitée du MOSFET à double grille,
(f) enlèvement sélectif de la couche de protection (5A),
(g) élaboration des zones de source et de drain (3B) dans la couche semi-conductrice (3), la couche d'isolant (4A) formée en premier servant de masque pour la protection du canal (3C) de la couche semi-conductrice lors du dopage des zones de source et de drain (3B),
(h) formation d'une deuxième couche d'isolant (6) sur la structure stratifiée existante (1 , 2B, 3B, 3C et 4B),
(i) formation d'une ouverture dans la structure mesa avec une profondeur atteignant le substrat porteur (1) ou la couche noyée (2B),
(j) formation de tunnels (T1, T2) le long de la structure mesa dans la couche d'isolant (4B) formée en premier et dans la couche noyée (2B),
(k) formation des diélectriques de grille (7) sur les deux côtés de la couche semi-conductrice (3),
(l) formation des électrodes de grille (8) sur les diélectriques de grille (7).

2. Procédé selon la revendication 1, dans lequel la couche semi-conductrice (3) est dopée de manière ciblée pour le réglage de la tension de seuil du transistor.

3. Procédé selon l'une quelconque des revendications précédentes, **caractérisé en ce que** le même matériau est utilisé pour la couche d'isolant (4, 4A, 4B) formée en premier et pour la couche noyée (2, 2A, 2B).

4. Procédé selon l'une quelconque des revendications précédentes, **caractérisé en ce que** la gravure sous-jacente latérale sélective est réalisée à l'aide d'une gravure par voie chimique humide et/ou d'une gravure sèche.

5. Procédé selon l'une quelconque des revendications précédentes, **caractérisé en ce qu'**une structure à symétrie inverse par rapport à la couche semi-conductrice à canal (3C) est constituée à partir de la couche d'isolant (4B) formée en premier et à partir de la couche noyée (2B).

6. Procédé selon l'une quelconque des revendications précédentes, **caractérisé en ce que** la deuxième couche d'isolant (6) est déposée à l'aide d'une déposition en phase gazeuse.

7. Procédé selon l'une quelconque des revendications précédentes, **caractérisé en ce qu'**une implantation supplémentaire pour des extensions de source et de drain avec des pièces intercalaires est réalisée sur la couche d'isolant (4B) formée en premier.

8. Procédé selon l'une quelconque des revendications précédentes, **caractérisé en ce que** la structure est malléabilisée pour l'activation des atomes de dopage.

9. Procédé selon l'une quelconque des revendications précédentes, **caractérisé en ce que** l'ouverture dans la structure mesa est réalisée sous forme d'un fossé transversal (H1), la largeur (L1) du fossé transversal (H1) étant supérieure à la largeur (L) de la couche d'isolant (4B) formée en premier.

10. Procédé selon l'une quelconque des revendications précédentes, **caractérisé en ce que** les tunnels (T1, T2) sont formés par gravure sélective par voie chimique humide.

11. Procédé selon l'une quelconque des revendications précédentes, **caractérisé en ce que** la longueur des tunnels (T1, T2) correspond à la largeur de canal des MOSFET à double grille.

12. Procédé selon l'une quelconque des revendications précédentes, **caractérisé en ce que** l'épaisseur de couche de la couche de canal (3C) est réduite par oxydation ou gravure.

13. Procédé selon l'une quelconque des revendications précédentes, **caractérisé en ce que** l'on utilise comme diélectrique de grille (7) du dioxyde de silicium produit thermiquement ou des oxynitrures ou un matériau à forte teneur en K tel qu'un oxyde de hafnium ou un oxyde de zirconium ou des silicates ou des oxydes de pérovskite.

14. Procédé selon l'une quelconque des revendications précédentes, **caractérisé en ce que** l'on utilise un polysilicium hautement dopé pour la formation des électrodes de grille (8).

15. Procédé selon l'une quelconque des revendications précédentes, **caractérisé en ce qu'**un métal est déposé à l'aide d'une déposition en phase gazeuse pour la formation des électrodes de grille (8).
